# EUROPEAN PATENT APPLICATION

(11) **EP 4 557 292 A1**
(43) Date of publication of application: **21.05.2025**
(21) Application number: 24213952.5
(22) Date of filing: 19.11.2024
(51) Int. Cl.: G11C 11/56, G11C 16/34

(54) **MEMORY DEVICE, MEMORY SYSTEM, AND OPERATING METHOD OF MEMORY DEVICE**

(30) Priority: 20.11.2023 KR 20230161437
(71) Applicant: Samsung Electronics Co., Ltd., Suwon-si, Gyeonggi-do 16677 (KR)
(72) Inventor: HAN, Guyeon, 16677 Suwon-si (KR); KANG, Jinkyu, 16677 Suwon-si (KR); JANG, Woojae, 16677 Suwon-si (KR)
(74) Representative: Marks & Clerk LLP

(57) **Abstract**

A memory device includes a plurality of memory cells configured to store at least one bit, the memory device comprising a first wordline and a second wordline. The memory device is configured to: perform a first programming operation on the first wordline on a plurality of memory cells in a higher state, the higher state referring to a state in which the plurality of memory cells have threshold voltages above a particular voltage; perform a second programming operation on the second wordline; and perform a third programming operation with a voltage lower than a voltage of the first programming operation when the second programming operation is performed after the first programming operation is performed.

## Description

### BACKGROUND

The inventive concept relates to a memory device, a memory system, and an operating method of a memory device, and more particularly, to a memory device, a memory system, and an operating method of a memory device, which improve interference for a victim wordline affected by a voltage distribution by an aggressor wordline.

Recently developed memory devices include a plurality of wordlines. When plurality of wordlines are individually programmed this can affect a voltage distribution of adjacent wordlines. For example, if an aggressor wordline is programmed after a victim wordline is programmed, a voltage distribution of the victim wordline is affected by the programming of the aggressor wordline.

To improve this, a re-program operation has been proposed. The re-program operation performs a programming operation on the victim wordline with a voltage lower than a threshold voltage and then performs a correction operation on the victim wordline again after performing the programming operation on the aggressor wordline.

However, the related art method, could not sufficiently eliminate interference caused by a programming voltage of the aggressor wordline.

### SUMMARY

Aspects of the inventive concept provide a memory device and a memory system that eliminate interference caused by a programming voltage of an aggressor wordline.

Aspects of the inventive concept also provide a memory device and a memory system that eliminate interference caused by the programming voltage of an aggressor wordline by utilizing a voltage higher than a threshold voltage when performing a programming operation on a victim wordline, even without an interference correction operation on the victim wordline.

According to an example embodiment, a memory device includes a plurality of memory cells configured to store at least one bit, the memory device comprising a first wordline and a second wordline. The memory device is configured to perform a first programming operation on the first wordline on a plurality of memory cells in a higher state, the higher state referring to a state in which the plurality of memory cells have threshold voltages above a particular voltage; perform a second programming operation on the second wordline; and perform a third programming operation with a voltage lower than a voltage of the first programming operation when the second programming operation is performed after the first programming operation is performed.

According to an example embodiment, an operating method of a memory device including a plurality of memory cells each storing at least one bit includes performing a first programming operation on memory cells connected to a first wordline, including applying a first voltage to the first wordline; and performing a second programming operation on memory cells connected to a second wordline adjacent to the first wordline, including applying a second voltage to the second wordline. In the performing of the first programming operation, the first programming operation is performed on memory cells in a higher state, the higher state referring to a state in which the memory cells have a threshold voltage above a particular voltage. When the second programming operation is performed after the first programming operation is performed, a third programming operation is performed on the memory cells connected to the first wordline, including applying a third voltage lower than the first voltage to the first wordline.

According to an example embodiment, a memory system includes a host configured to generate a re-program command for a wordline; and a memory device configured to receive the re-program command, the memory device including a plurality of memory cells each storing at least one bit, and configured to performing a re-program operation. The memory device includes a first wordline on which a first programming operation is configured to be performed, and a second wordline on which a second programming operation is configured to be performed. The memory device is configured to perform the first programming operation on a memory cell in a higher state, the higher state referring to a state in which the memory cell has a threshold voltage above a particular voltage, and to perform a third programming operation with a voltage lower than a voltage for the first programming operation when the second programming operation is performed after the first programming operation is performed.

According to an embodiment, there is provided a memory device including a plurality of memory cells, wherein each memory cell is configured to store at least one bit. The memory device may comprise a first wordline comprising a first plurality of memory cells and a second wordline comprising a second plurality of memory cells. The memory device may be configured to: perform a first programming operation on the first wordline; perform a second programming operation on the second wordline; and perform a third programming operation with a voltage lower than a voltage of the first programming operation when the second programming operation is performed after the first programming operation is performed.

The first wordline may be adjacent to the second wordline. The third programming operation may be performed on the first wordline. Each programming operation may be performed on a select subset of the memory cells on the corresponding bit line, the select subset may be those memory cells that are to be programmed to a higher programming state based on a write command. For instance, a logical address in the write command may be mapped to a physical address within the memory device. Each memory cell on a given wordline may be programmed to a lower state or a higher state, wherein a lower state is a state in which the memory cell has a threshold voltage below a particular voltage and a higher state is a state in which the memory cell has a threshold voltage above the particular voltage. The required state of the memory cell may be defined based on the value that is required to be written to that cell (e.g. based on the write command). Only those memory cells that are required to be programmed to a higher state may be selected for programming. For instance, a first subset of the first plurality of memory cells may be selected for programming in the first programming operation. Similarly, a second subset of the second plurality of memory cells may be selected for programming in the second programming operation.

According to an embodiment, the memory device is configured to, when one or more of the first subset of the first plurality of memory cells of the first wordline are in a lower state and one or more of the second subset of the second plurality of memory cells of the second wordline are in a lower state, the lower state referring to a state in which the plurality of memory cells have threshold voltages below a particular voltage, perform a fifth programming operation on the second wordline when (e.g. in response to) a fourth programming operation is performed on a third wordline adjacent to the second wordline. The fifth programming operation may be performed on the one or more of the second subset of the second plurality of memory cells (e.g. any memory cells of the second subset of memory cells that have not been programmed to the higher memory state). The fifth programming operation may be performed if the one or more of the first subset of the plurality of memory cells of the first wordline are in the lower state and the one or more of the second subset of the second plurality of memory cells of the second wordline are in the lower state after the fourth programming operation has been performed.

According to an embodiment, the memory device is configured to stop (e.g. inhibit or prevent) an additional programming operation from being performed on the first wordline after the third programming operation when the first subset of the first plurality of memory cells of the first wordline are in a lower state (e.g. when one or more of the first subset are in a lower state) and the second subset of the second plurality of memory cells of the second wordline are in a higher state (e.g. when each of the second subset are in a higher state), the lower state referring to a state in which respective memory cells have threshold voltages below a particular voltage, and the higher state referring to a state in which respective memory cells have threshold voltages above the particular voltage.

According to an embodiment the memory device is configured to omit the third programming operation on the first wordline when the first subset of the first plurality of memory cells of the first wordline are in a higher state.

At least some of the above and other features of the invention are set out in the claims.

### BRIEF DESCRIPTION OF THE DRAWINGS

Embodiments will be more clearly understood from the following detailed description taken in conjunction with the accompanying drawings in which:
FIG. 1 is a block diagram of a memory system according to an embodiment;
FIG. 2 is a block diagram of a memory device according to an embodiment;
FIG. 3 is a conceptual diagram illustrating wordlines of a memory device according to an embodiment;
FIG. 4 is a conceptual diagram illustrating programming on wordlines according to an embodiment;
FIG. 5A is a conceptual diagram illustrating programming processes of wordlines when a first wordline is in a lower state and a second wordline is in a lower state, according to an embodiment;
FIG. 5B is a conceptual diagram illustrating programming processes of wordlines when the first wordline is in a lower state and the second wordline is in a higher state, according to an embodiment;
FIG. 5C is a conceptual diagram illustrating programming processes of wordlines when the first wordline is in a higher state and the second wordline is in a lower state, according to an embodiment;
FIG. 5D is a conceptual diagram illustrating a programming process of a wordline when the first wordline is in a higher state and the second wordline is in a higher state, according to an embodiment;
FIG. 5E shows a diagram of a voltage distribution after programming a wordline according to an embodiment;
FIG. 6 is a flowchart of a method of programming a memory device according to an embodiment;
FIG. 7 is a flowchart illustrating a programming process for a memory device when the first wordline is in a lower state and the second wordline is in a lower state, according to an embodiment;
FIG. 8 is a flowchart illustrating a programming process for a memory device when the first wordline is in a lower state and the second wordline is in a higher state, according to an embodiment;
FIG. 9 is a conceptual diagram illustrating a programming process for a memory device when the first wordline is in a higher state, according to an embodiment; and
FIGS. 10 to 12 are diagrams illustrating a three-dimensional V-NAND structure that may be applied to a memory device according to an embodiment.

### DETAILED DESCRIPTION OF THE EMBODIMENTS

Hereinafter, embodiments are described along with the attached drawings. Hereinafter, details, such as a detailed configuration and a structure are provided to help understand the embodiments. Therefore, the embodiments described herein may be changed or modified in various ways without departing from the invention.

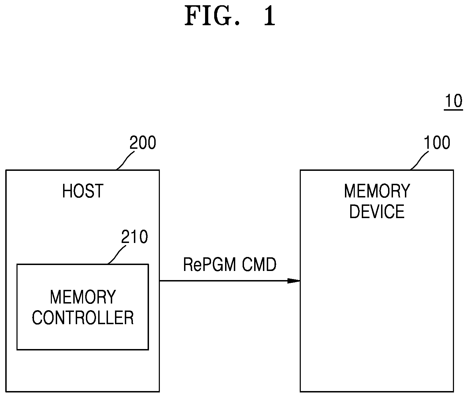

FIG. 1 is a block diagram of a memory system 10 according to an embodiment.

Referring to FIG. 1, the memory system 10 according to an embodiment includes a memory device 100 and a host 200. The memory device 100 according to an embodiment may receive a re-program command RePGM CMD generated by the host 200 and perform a re-program operation on a plurality of wordlines included in the memory device 100. Hereinafter, the re-program operation used in this specification is an operation of performing a programming operation on a first wordline among a plurality of wordlines included in the memory device 100, performing a programming operation on a second wordline adjacent to the first wordline after the programming operation on the first wordline, and then, performing the programming operation again on the first wordline affected by the programming operation on the second wordline. Here, the first wordline may be a victim wordline and the second wordline may be an aggressor wordline. For example, the re-program operation may be an operation to correct the voltage distribution of cells connected to the victim wordline affected by the programming operation for the aggressor wordline. In the present application, an aggressor wordline may be a wordline that is subject to a programming operation that affects a neighboring wordline. Similarly, a victim wordline may be a wordline that is affected by a programming operation performed on a neighboring wordline. The cells of a victim wordline may be programmed to respective voltage distributions such that the programming performed on the aggressor wordline affects the programmed voltage distributions of the cells of the victim wordline.

The memory device 100 according to an embodiment may store at least one bit in each of a plurality of cells and perform the re-program operation. For example, the memory device 100 may include a plurality of wordlines and store at least one bit in each of a plurality of memory cells connected to each wordline. The memory device 100 according to an embodiment may include a first wordline on which a first programming operation is performed and a second wordline on which a second programming operation is performed. The first wordline may be adjacent to the second wordline. The first programming operation according to an embodiment may be performed temporally before the second programming operation. For example, after the first programming operation is performed on the first wordline (e.g., on cells connected to the first wordline), the second programming operation may be performed on the second wordline (e.g., on cells connected to the second wordline), thereby changing a distribution of the cells connected to the first wordline.

The programming operations of the memory device 100 may be controlled by circuitry within the memory device 100 (e.g. one or more voltage generators, control logic, a row decoder, a column decoder, etc.).

For instance, control logic may, based on a command (e.g. received from the memory controller 210), write or program data into memory cells, verify programmed data, read data from the memory cells, or output voltage control signals for erasing data stored in the memory cells. In this manner, the control logic may control all of various operations in the memory device 100.

A voltage generator may generate various kinds of voltages for performing program, read, and erase operations on the memory cells based on a voltage control signal received from the control logic. The voltage generator may generate a word line voltage, for example, a program voltage, a read voltage, a pass voltage, an erase verify voltage, or a program verify voltage. In addition, the voltage generator may further generate a string selection line voltage and a ground selection line voltage based on the voltage control signal.

A row decoder may, in response to a row address signal received from the control logic, perform a selection operation on the plurality of word lines and a selection operation on a plurality of string selection lines. In addition, a page buffer circuit may select at least one bit line among the bit lines in response to a column address signal received from the control logic. Each of the page buffers of the page buffer circuit may operate as a write driver or a sense amplifier according to an operation mode.

The page buffer circuit may include a plurality of page buffers arranged to correspond to a plurality of bit lines. Each of the page buffers may be connected to a corresponding bit line among the plurality of bit lines. The page buffer circuit may temporarily store data read from the memory cell array, or may temporarily store data to be recorded in the memory cell array. For example, each of the page buffers may include one or more latches. Each of the latches may temporarily store data.

The first wordline of the memory device 100 according to an embodiment may be configured to perform the first programming operation on a cell to place the cell in a higher state (e.g., data state), and when the second programming operation is performed after the first programming operation is performed, the first wordline may be configured to perform a third programming operation with a voltage lower than that of the first programming operation. The third programming operation according to an embodiment may be a re-program operation for the first wordline. For example, the first programming operation may place the cell to have a threshold voltage above a certain level, which places the cell in a first, higher, data state.

According to an embodiment, a voltage used in the third programming operation may be set to be lower than the voltage of the first programming operation, and thus, when cells of the first wordline have a higher state from among a group of states that represent different values (e.g., from among states of a multi-level cell), the memory device 100 may have an effect as if (e.g. equivalent to) the third programming operation was omitted for those cells (e.g. the higher state cells may be unaffected by the third programming operation). For example, because the first programming operation is performed at a higher voltage than the third programming operation, the memory device 100 may form a voltage distribution that takes into account the re-program operation on the first wordline when performing the first programming operation. When cells of the first wordline have a threshold voltage corresponding to a lower state from among a group of states that represent different values (e.g., from among states of a multi-level cell), the memory device 100 may perform the third programming operation with a lower voltage than the voltage applied in the first programming operation. A higher state according to an embodiment may be a state among a set of possible states for memory cells programmed that has a voltage distribution at a level higher than a particular threshold voltage, and a lower state may be a state among a set of possible states for memory cells programmed to have a voltage distribution at a level lower than the particular threshold voltage.

The host 200 according to an embodiment may include a memory controller 210 and may generate a re-program command RePGM CMD for the memory device 100. For example, the memory controller 210 may generate the re-program command RePGM CMD for the memory device 100 and transmit the generated re-program command RePGM CMD to the memory device 100. The memory device 100 may receive the re-program command RePGM CMD and perform a re-program operation on wordlines.

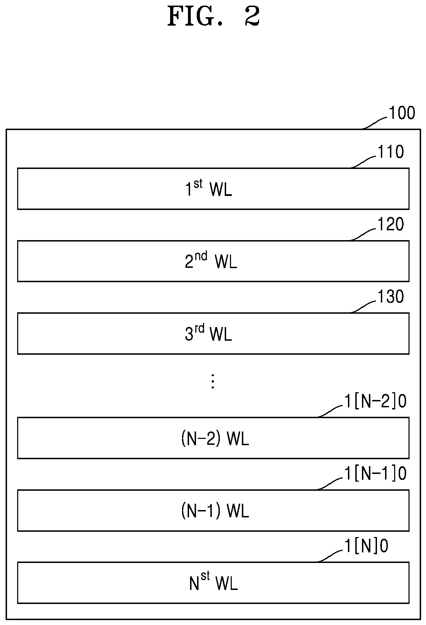

FIG. 2 is a block diagram of the memory device 100 according to an embodiment.

Referring to FIG. 2, the memory device 100 according to an embodiment may include a first wordline 110, a second wordline 120, and a third wordline 130. However, as shown in FIG. 2, the memory device 100 may further include a plurality of wordlines including an (N-2)-th wordline 1[N-2]0, an (N-1)-th wordline 1[N-1]0, and/or an N-th wordline 1[N]0. However, in this specification, for convenience, the description will focus on the first wordline 110, the second wordline 120, and the third wordline 130. The first wordline 110 according to an embodiment may be a victim wordline for the second wordline 120. In addition, the second wordline 120 may be a victim wordline for the third wordline 130. For example, in the case of performing a programming operation on the second wordline 120 after the programming operation on the first wordline 110 is performed, the first wordline 110 may experience a change in its voltage distribution when the programming operation on the second wordline 120 is performed, and may therefore be a victim wordline for the second wordline 120. The second wordline 120 may therefore be an aggressor wordline for the first wordline 110. Similarly, in the case of performing a programming operation on the third wordline 130 after the programming operation on the second wordline 120, the second wordline 120 may experience a change in its voltage distribution during the programming operation on the third wordline 130, and may therefore be a victim wordline for the third wordline 130. The third wordline 130 may therefore be an aggressor wordline for the second worldline 120. Each of the first wordline 110, the second wordline 120, and the third wordline 130 according to an embodiment may include a plurality of memory cells (e.g., may be connected to gates of the plurality of memory cells).

The first wordline 110 according to an embodiment may perform the first programming operation on a cell in a higher state. After the first programming operation is performed, the second wordline 120 according to an embodiment may perform the second programming operation. After the second programming operation is performed, the first wordline 110 according to an embodiment may perform the third programming operation. The third programming operation according to an embodiment may be a re-program operation for the first wordline 110. A voltage of the third programming operation according to an embodiment may be at a lower level than a voltage of the first programming operation.

For example, the first wordline 110 performs the first programming operation on the cell in a higher state, and when the second programming operation is performed after the first programming operation is performed, the first wordline 110 may perform the third programming with a lower voltage than the voltage of the first programming operation. According to an embodiment, the third programming operation is set to be lower than the voltage of the first programming operation, and thus, when the cells connected to the wordline have a higher state, and thus a higher threshold voltage, the third programming operation on the first wordline 110 may have an effect as if (e.g. equivalent to) the third programming operation was omitted (e.g. the higher state cells may be unaffected by the third programming operation). For example, because the first programming operation is performed at a higher voltage than the third programming operation, the cells connected to the first wordline 110 may form a voltage distribution that takes into account the re-program operation on the first wordline 110 when performing the first programming operation.

The first wordline 110 according to an embodiment may perform the first programming operation using a voltage higher than the threshold voltage of a plurality of memory cells. For example, the first wordline 110 may perform a first programming operation using a voltage higher than the threshold voltage of the memory cell to form a voltage distribution of memory cells with a higher state.

According to an embodiment, when cells connected to the first wordline 110 are programmed to have a lower state, and a voltage is subsequently supplied to the second wordline 120 to place cells connected to the second wordline 120 in a higher state, the first wordline 110 may be configured to stop further programming operations performed after the third programming operation is performed. For example, the first wordline 110 having a voltage distribution affected by the second programming operation may correct the voltage distribution by performing the third programming operation, and may not perform any additional re-program operations thereafter.

According to an embodiment, when cells connected to the first wordline 110 are programmed to have a higher state, the first wordline 110 may be configured to omit the third programming operation. For example, when the first programming operation for the first wordline 110 is performed to result in all cells intended to be programmed having a high voltage threshold voltage distribution exceeding a particular threshold voltage, the first wordline 110 may omit the third programming operation. When the cells connected to the first wordline 110 according to an embodiment have recently been programmed to be in a higher state and the cells connected to the second wordline 120 have recently been programmed to be in a lower state or when the cells connected to the first wordline 110 according to an embodiment have recently been programmed to be in a higher state and the cells connected to the second wordline 120 have recently been programmed to be in a higher state, the first wordline 110 may omit the third programming operation.

The second wordline 120 according to an embodiment may be a wordline adjacent to the first wordline 110. For example, the second wordline 120 may be disposed adjacent to the first wordline 110, and the voltage distribution of cells connected to the first wordline 110 may be affected due to the performing of the second programming operation on the second wordline 120. When voltage distribution of cells connected to the first wordline 110 is affected due to the second programming operation of the second wordline 120, the first wordline 110 according to an embodiment may perform the third program operation depending on a state.

The second wordline 120 according to an embodiment may perform a fifth programming operation according to a fourth programming operation for the third wordline 130. For example, when cells connected to the first wordline 110 have recently been programmed to be in a lower state and cells connected to the second wordline 120 have recently been programmed to be in a lower state, when the fourth programming operation is performed on the third wordline 130 adjacent to the second wordline 120, the second wordline 120 may be configured to perform the fifth programming operation. The fourth programming operation according to an embodiment may be a programming operation performed on the third wordline 130 after a re-program operation on the first wordline 110. The fifth programming operation according to an embodiment may be a re-program operation for the second wordline 120.

A voltage used for the fifth programming operation according to an embodiment may be at a lower level than the voltage of the second programming operation. For example, in a case in which the second wordline 120 has recently programmed cells connected to the second wordline 120 to be in a higher state, when the fourth programming operation is performed after the second programming operation is performed, the second wordline 120 may be configured to perform the fifth programming operation with a voltage lower than the voltage of the second programming operation. According to an embodiment, the fifth programming operation may be set to be lower than the voltage of the second programming operation, and thus, when cells connected to the second wordline 120 have been programmed to a higher state, the second wordline 120 may have an effect as if (e.g. equivalent to) the fifth programming operation was omitted. Because the second programming operation is performed at a higher voltage than the fourth programming operation, the second wordline 120 may form a voltage distribution that takes into account a re-program operation on the second wordline 120 when performing the second programming operation.

The first wordline 110 and the second wordline 120 according to an embodiment may be configured to include a quad level cell (QLC) or a triple level cell (TLC) (e.g. a multi-level cell). That is, the cells of the first wordline 110 and the second wordline 120 may be quad level cells or triple level cells (e.g. multi-level cells). However, this embodiment is not limited to the first wordline 110 and the second wordline 120, and additional wordlines included in the memory device 100 may be configured to include quad level cells or triple level cells. For the memory to include quad-level cells or triple-level cells (e.g. multi-level cells), the wordlines according to an embodiment may store at least two bits in one memory cell.

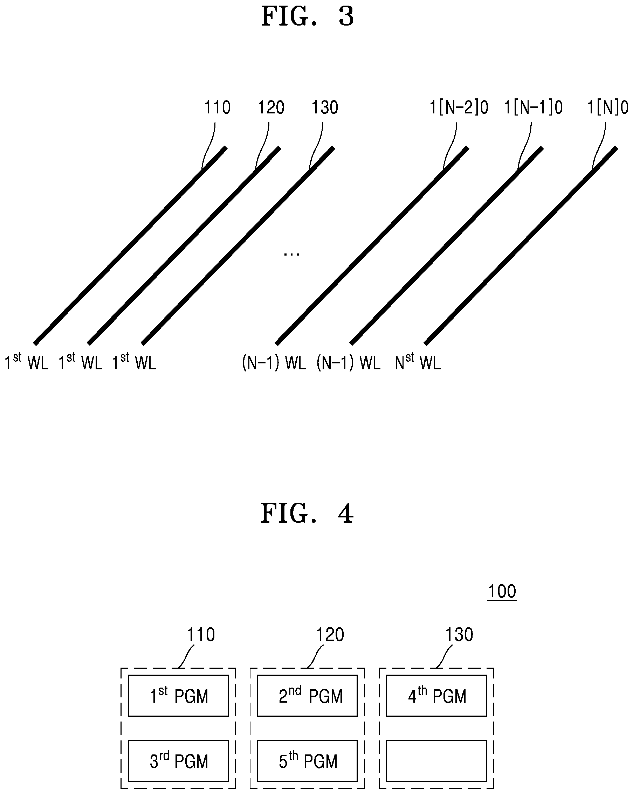

FIG. 3 is a conceptual diagram illustrating wordlines of the memory device 100 according to an embodiment.

Referring to FIG. 3, the memory device 100 according to an embodiment may include a plurality of wordlines. For example, the memory device 100 may include a first wordline 110, a second wordline 120, and a third wordline 130. However, as shown in FIG. 3, the memory device 100 may further include an (N-2)-th wordline 1[N-2]0, an (N-1)-th wordline 1[N-1]0, or an N-th wordline 1[N]0. The wordlines may be located to be adjacent to each other. In an embodiment, because different wordlines are arranged to be adjacent to each other, each wordline may be affected by a voltage distribution according to a programming operation of the adjacent wordline. For example, a voltage distribution of the first wordline 110 may be affected due to a programming operation on the second wordline 120. However, by performing the first programming operation on the first wordline 110 using a voltage exceeding the threshold voltage of all cells being programmed, resulting on the programmed cells all having a higher state, the first wordline 110 may not be affected by the second programming operation. For example, by setting the first programming operation so that all cells of the first wordline 110 that are intended to be programmed to a higher state actually have a higher state, the memory device 100 may omit the re-program operation on the first wordline 110 or may perform the re-program operation on the first wordline 110 with a voltage lower than a first programming voltage.

FIG. 4 is a conceptual diagram illustrating programming on wordlines according to an embodiment.

Referring to FIG. 4, the memory device 100 according to an embodiment may include the first wordline 110, the second wordline 120, and/or the third wordline 130 and may perform a programming operation on each wordline.

The first wordline 110 of the memory device 100 according to an embodiment may perform a first programming operation 1st PGM or a third programming operation 3rd PGM. The second wordline 120 of the memory device 100 according to an embodiment may perform a second programming operation 2nd PGM or a fifth programming operation 5th PGM. The third wordline 130 of the memory device 100 according to an embodiment may perform a fourth programming operation. In describing the first to fifth programming operations according to an embodiment, the terms 'first to fifth' may be determined according to the programming order. For example, the memory device 100 according to an embodiment may perform the second programming operation on the second wordline 120 after performing a first programming operation on the first wordline 110. When (e.g. in response to) the second programming operation is performed, the memory device 100 according to an embodiment may subsequently perform the third programming operation on the first wordline 110. The third programming operation may be a re-program operation for the first wordline 110. When (e.g. in response to) the third programming operation is completed, the memory device 100 according to an embodiment may perform the fourth programming operation on the third wordline 130. When (e.g. in response to) the fourth programming operation is performed, the memory device 100 according to an embodiment may subsequently perform the fifth programming operation on the second wordline 120. The fifth programming operation according to an embodiment may be a re-program operation for the second wordline 120.

The programming operations may be performed on a selection of cells on the respective wordlines. For instance, in some embodiments, only those cells that are required to be programmed to a higher state (e.g. based on a write command) may be programmed. When reprogramming is performed on a wordline, all cells that are to be programmed to a higher state may be reprogrammed. According to an embodiment, when the first wordline 110 initially programs all memory cells to be programmed to a higher state to the higher state, and the memory cells remain in the higher state after a second programming operation on the second wordline 120, the first wordline 110 may be configured to omit the third programming operation. For example, when the first programming operation is performed on the first wordline 110 so that all cells connected to the first wordline 110 and being programmed to a higher state have a voltage threshold distribution exceeding a particular threshold voltage (corresponding to the higher state) by a sufficient amount such that any change in threshold voltage due to programming of the second wordline 120 does not lower the threshold voltage of any cells below the particular threshold voltage, then the first wordline 110 may omit the third programming operation or may perform the third programming operation with a voltage lower than the voltage of the first programming operation to have an effect as if (e.g. equivalent to) the third programming operation was omitted. That is, the third programming operation may only be performed if there are any cells on the first wordline 110 that are required to be programmed to the higher state that are not programmed to the higher state (e.g. following the first and second programming operations).

According to an embodiment, when the second wordline 120 is in a higher state, the second wordline 120 may be configured to omit the fifth programming operation. For example, when the second programming operation is performed on the second wordline 120 so that all cells connected to the second wordline 120 and being programmed to a higher state have a voltage threshold distribution exceeding a particular threshold voltage by a sufficient amount such that any change in threshold voltage due to programming of the third wordline 130 does not lower the threshold voltage of any cells below the particular threshold voltage, then the second wordline 120 may omit the fifth programming operation or perform the fifth programming operation with a voltage lower than the voltage of the second programming operation to have an effect as if (e.g. equivalent to) the fifth programming operation was omitted.

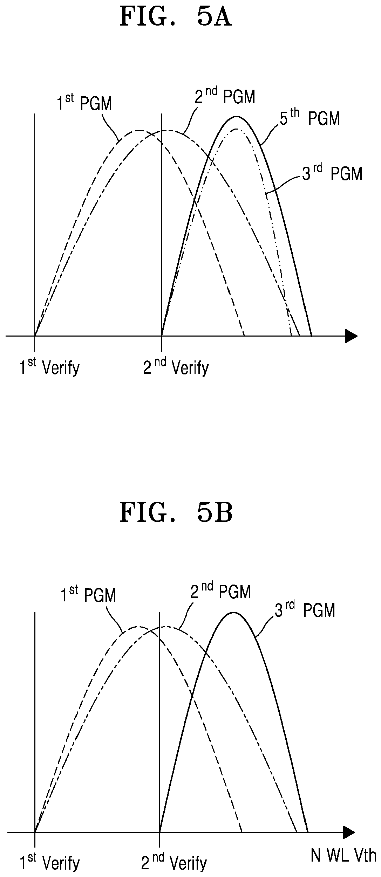

FIG. 5A is a conceptual diagram illustrating programming processes of wordlines when the cells connected to the first wordline (e.g. at least the selected cells of the first wordline that are to be programmed to a higher state) are programmed to be in a lower state and the cells connected to the second wordline (e.g. at least the selected cells of the second wordline that are to be programmed to a higher state) are programmed to be in a lower state, according to an embodiment. The lower states in this example refer to one or more lower states among a set of states that represent all bit values for a memory cell. A state may be a lower state if there is at least one potential programming state that is higher than it in the multi-level cell. A state may be a higher state if there is at least one potential programming state that is lower than it in the multi-level cell. For example, the lower state may refer to either of a P0 and P1 state in a multi-level cell. The higher states in this example refer to one or more higher states among a set of states that represent all bit values for a memory cell. For example, the higher state may refer to any of a P2 through P7 state in a multi-level cell (e.g. a TLC). In the following description, the state of a wordline may be based on the voltage distribution of those cells that are to be programmed to a higher state. Accordingly, the voltage distributions for each wordline may relate only to those cells being programmed to a higher state according to a corresponding write command, and the programming operations may be performed only on those cells that are to be programmed to a higher state. A voltage distribution may be considered to exceed a particular voltage level (e.g. a verify voltage level) if all cells being considered (e.g. having their threshold voltage checked) have a threshold voltage above the particular level. A voltage distribution may be considered not to exceed a particular voltage level (e.g. a verify voltage level) if at least one cell being considered (e.g. having its threshold voltage checked) has a threshold voltage below the particular level.

In the embodiment of FIG. 5A, the horizontal axis may be the voltage level N WL Vth of the N-th wordline. The vertical axis may be the number of cells (e.g. the number of cells at a particular voltage level). The N-th wordline according to an embodiment may have a first threshold voltage 1st Verify and a second threshold voltage 2nd Verify. A higher state according to an embodiment may be a state having a voltage threshold distribution higher than the second threshold voltage 2nd Verify, and a lower state may be a state having a voltage threshold distribution lower than the second threshold voltage 2nd Verify. Hereinafter, the embodiment of FIG. 5A is described based on the voltage threshold distribution of the first wordline.

Referring to FIGS. 2 and 5A, when the first wordline 110 is in a lower state and the second wordline 120 is in a lower state (e.g. after the first programming operation), the memory device 100 according to an embodiment may perform the second programming operation on the second wordline 120 after the first programming operation on the first wordline 110. When the second programming operation is performed, the memory device 100 according to an embodiment may perform the third programming operation on the first wordline 110. The third programming operation may be a re-program operation for the first wordline 110, and it may be performed after the second programming operation is performed. When the third programming operation is completed, the memory device 100 according to an embodiment may perform the fourth programming operation on the third wordline 130. When the fourth programming operation is performed, the memory device 100 according to an embodiment may perform the fifth programming operation on the second wordline 120. The fifth programming operation according to an embodiment may be a re-program operation for the second wordline 120. As a result of the re-program operations on the first wordline 110 and second wordline 120, the programmed cells connected the first wordline 110 may have the voltage threshold distribution labeled 1^{st} PGM after the first programming operation, 2^{nd} PGM after the second programming operation, 3^{rd} PGM after the third programming operation, and 5^{th} PGM after the fifth programming operation. Therefore, after both the fourth and fifth programming operation, the programmed cells connected to the first wordline 110 have a voltage distribution above the 2^{nd} verify voltage, which may correspond to a higher state (e.g., a P2 state) among a plurality of states that the cells can be in. So in FIG. 5A, the final state labeled 5^{th} PGM (above the 2^{nd} Verify voltage) may be a P2 state among states P0-P7 in a multi-level cell memory.

When memory cells connected to the first wordline 110 are programmed to be in a lower state and memory cells connected to the second wordline 120 are programmed to be in a lower state (e.g. after the first program operation), the memory device 100 according to an embodiment may perform the re-program operation on the first wordline 110 and the second wordline 120 to correct the voltage threshold distributions of the first wordline 110 and the second wordline 120.

FIG. 5B is a conceptual diagram illustrating programming processes of wordlines when programmed cells connected to the first wordline are programmed to be in a lower state and the programmed cells connected to the second wordline are programmed to be in a higher state, according to an embodiment.

In the embodiment of FIG. 5B, the horizontal axis may be the voltage level N WL Vth of the N-th wordline. The vertical axis may be the number of cells (e.g. the number of cells at a particular voltage level). The N-th wordline according to an embodiment may have the first threshold voltage 1st Verify and the second threshold voltage 2nd Verify. A higher state according to an embodiment may be a state having a voltage threshold distribution higher than that of the second threshold voltage 2nd Verify, and a lower state may be a state having a voltage threshold distribution lower than that of the second threshold voltage 2nd Verify. Hereinafter, the embodiment of FIG. 5B is described based on the voltage distribution of the first wordline. In FIG. 5B, for example, a first state shown (e.g., the state between 1^{st} Verify and 2^{nd} Verify) may be a lower state among a plurality of states in an MLC memory (e.g., states P0 and P1) and a second state shown (e.g., the state above 2^{nd} Verify) may be a higher state among a plurality of states in an MLC memory (e.g., states P2-P7).

Referring to FIGS. 2 and 5B, when the programmed cells connected to the first wordline 110 are in a lower state and the programmed cells connected to the second wordline 120 are in a higher state (e.g. after the second programming operation) according to an embodiment, the first wordline 110 may be configured to stop a programming operation performed after the third programming operation. For example, the first wordline 110 connected to programmed cells that have a voltage distribution affected by the second programming operation may perform the third programming operation to correct the voltage distribution and may not perform any additional re-program operation.

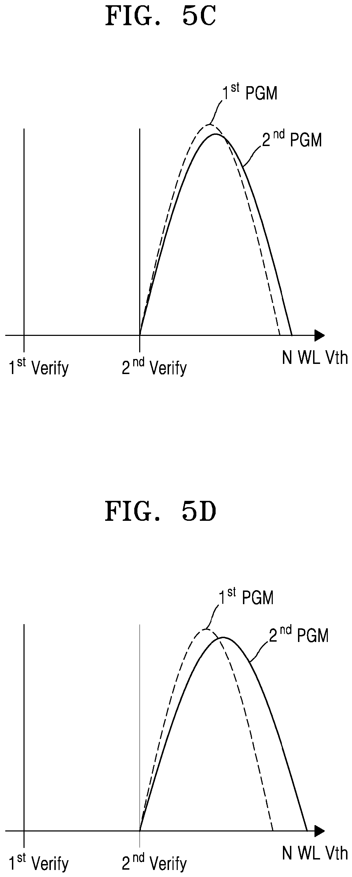

FIG. 5C is a conceptual diagram illustrating programming processes of wordlines when the programmed cells connected to the first wordline are in a higher state and the programmed cells connected to the second wordline are in a lower state, according to an embodiment, and FIG. 5D is a conceptual diagram illustrating programming processes of wordlines when the programmed cells connected to the first wordline are in a higher state and the programmed cells connected to the second wordline are in a higher state, according to an embodiment. In FIGS. 5C and 5D, for example, a first state shown (e.g., the state between 1^{st} Verify and 2^{nd} Verify) may be a lower state among a plurality of states in an MLC memory (e.g., states P0 and P1) and a second state shown (e.g., the state above 2^{nd} Verify) may be a higher state among a plurality of states in an MLC memory (e.g., states P2-P7).

In the embodiment of FIGS. 5C and 5D, the horizontal axis may be the voltage level N WL Vth of the N-th wordline. The vertical axis may be the number of cells (e.g. the number of cells at a particular voltage level). The N-th wordline according to an embodiment may have the first threshold voltage 1st Verify and the second threshold voltage 2nd Verify. A higher state according to an embodiment may be a state having a voltage distribution of memory cells higher than that of the second threshold voltage 2nd Verify, and a lower state may be a state having a voltage distribution of memory cells lower than that of the second threshold voltage 2nd Verify. Hereinafter, the embodiment of FIGS. 5C and 5D is described based on the voltage distribution of the first wordline.

Referring to FIGS. 2, 5C, and 5D, when the programmed cells connected to the first wordline 110 according to an embodiment are in a higher state, the first wordline 110 may be configured to omit the third programming operation regardless of the state of the cells of the second wordline 120. This may be based on the state of the first wordline 110 after the first programming operation or after the second programming operation. For instance, if the first wordline 110 is in a higher state and the second wordline 120 is in a lower state after the first programming operation, then the second programming operation may be performed but the third programming operation may be omitted. Alternatively, if the first wordline 110 is in a higher state and the second wordline 120 is in a higher state after the second programming operation, then the third programming operation may be omitted

For example, when the first programming operation for the first wordline 110 is performed to have a distribution of memory cells having a high voltage (e.g. a voltage exceeding the threshold voltage), the first wordline 110 may omit the third programming operation. When programmed cells connected to the first wordline 110 according to an embodiment are in a higher state and the programmed cells connected to the second wordline 120 are in a lower state or when the programmed cells connected to the first wordline 110 according to an embodiment are in a higher state and the programmed cells connected to the second wordline 120 are in a higher state, the first wordline 110 may omit the third programming operation. For example, when the first programming operation for the first wordline 110 is performed to result in programmed cells of the first wordline 110 exceeding the second threshold voltage 2nd Verify, the programmed cells connected to the first wordline 110 may not be affected by the second programming operation and the memory device 100 may omit the re-program operation. By omitting the re-program operation, the memory device 100 may have reduced power consumption.

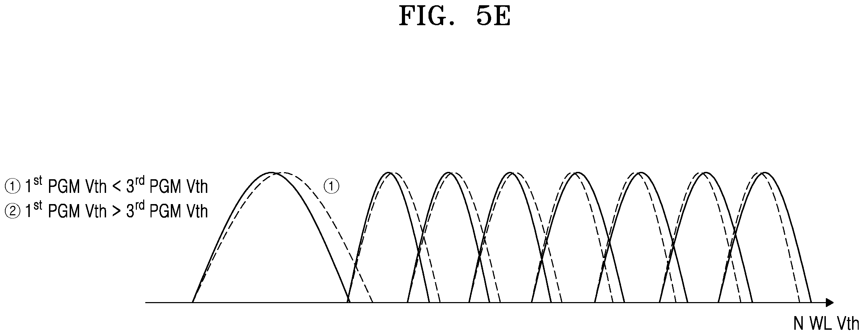

FIG. 5E shows a diagram of a voltage distribution after programming a wordline according to an embodiment. In the embodiment of FIG. 5E, the horizontal axis represents the voltage level N WL Vth of the N-th wordline. The vertical axis may be the number of cells (e.g. the number of cells at a particular voltage level).

Referring to FIGS. 2 and 5E, when the programmed cells connected to the first wordline according to an embodiment have a voltage in a lower state, the memory device 100 may perform the third programming operation using the third programming voltage 3rd PGM Vth having a higher level than that of the first programming operating voltage 1 st PGM Vth. For example, when the programmed cells connected to the first wordline 110 are in a lower state, the memory device 100 may perform re-program operation on the first wordline 110 after the second programming operation is performed on the second wordline 120. The third program operation according to an embodiment may be a re-program operation for the first wordline 110. When the programmed cells connected to the first wordline 110 according to an embodiment are in a lower state, the third programming operating voltage 3rd PGM Vth may have a higher level than that of the first programming operating voltage 1st PGM Vth. A higher state according to an embodiment may be a state in which memory cells are programmed to have a voltage distribution having a higher level than the threshold voltage, and a lower state may be a state in which memory cells are programmed to have a voltage distribution having a lower level than the threshold voltage.

Referring again to FIGS. 2 and 5E, the first wordline of the memory device 100 according to an embodiment may perform the first programming operation on a cell in a higher state, and when the second programming operation is performed after the first programming operation is performed, the first wordline may perform the third programming operation with the third programming voltage 3rd PGM Vth having a lower level than that of the first programming operating voltage 1st PGM Vth. The third programming operation according to an embodiment may be a re-program operation for the first wordline. According to an embodiment, the third programming operation may be set to be lower than the voltage of the first programming operation so that when the first wordline has a higher state voltage, the memory device 100 may have an effect as if (e.g. equivalent to) the third programming operation was omitted. For example, because the first programming operation is performed with a higher voltage than the third programming operation, the memory device 100 may form a voltage distribution that takes into account the re-program operation on the first wordline when performing the first programming operation.

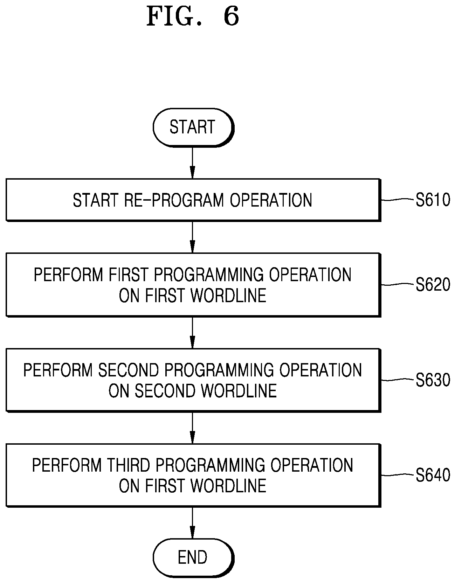

FIG. 6 is a flowchart of a method of programming the memory device 100 according to an embodiment.

Referring to FIGS. 2 and 6, the memory device 100 according to an embodiment may start a re-program operation (S610).

The re-program operation according to an embodiment may be an operation of performing a programming operation on the first wordline 110 among the wordlines included in the memory device 100, performing a programming operation on the second wordline 120 adjacent to the first wordline 110 after the programming operation on the first wordline 110, and then performing the programming operation again on the first wordline 110 that is affected by the programming for the second wordline 120. Here, the first wordline 110 may be a victim wordline and the second wordline 120 may be an aggressor wordline. The re-program operation may be an operation to correct a voltage distribution of programmed cells of the victim wordline affected by the programming operation for the aggressor wordline.

When the re-program operation starts, the memory device 100 according to an embodiment may perform a first programming operation on the first wordline 110 (S620). The first programming operation according to an embodiment may be an operation of performing a write operation on the first wordline 110.

After the first programming operation is performed on the first wordline 110, the memory device 100 according to an embodiment may perform a second programming operation on the second wordline 120 (S630). The second programming operation according to an embodiment may be an operation of performing a write operation on the second wordline 120.

After the second programming operation is performed on the second wordline 120, the memory device 100 according to an embodiment may perform a third programming operation on the first wordline 110 (S640). The third programming operation according to an embodiment may be a re-program operation for the first wordline 110. A voltage of the third programming operation according to an embodiment may have a lower level than a voltage of the first programming operation.

For example, the memory device 100 may perform the first programming operation on the first wordline 110, and when the second programming operation is performed after the first programming operation is performed, the memory device 100 may perform the third programming operation with a lower voltage than the voltage of the first programming operation. According to an embodiment, the third programming operation may be set to be lower than the voltage of the first programming operation so that when the programmed cells connected to the first wordline 110 have a higher state voltage distribution, the first wordline 110 may have an effect as if (e.g. equivalent to) the third programming operation was omitted. Therefore, because the first programming operation is performed at a higher voltage than the third programming operation, the first wordline 110 may form a voltage distribution that takes into account the re-program operation in the first wordline 110 when performing the first programming operation. For instance, the first programming operation may be performed over one or more programming steps that each apply a programming voltage to the memory cells on the first wordline 110. After one or more programming steps, the voltage distribution may be checked, and depending on the voltage distribution, one or more further programming steps may be performed. The first programming operation may be performed to result in a voltage distribution that is wider, and at a lower voltage, than ultimately desired, in the knowledge that the re-program operation will follow.

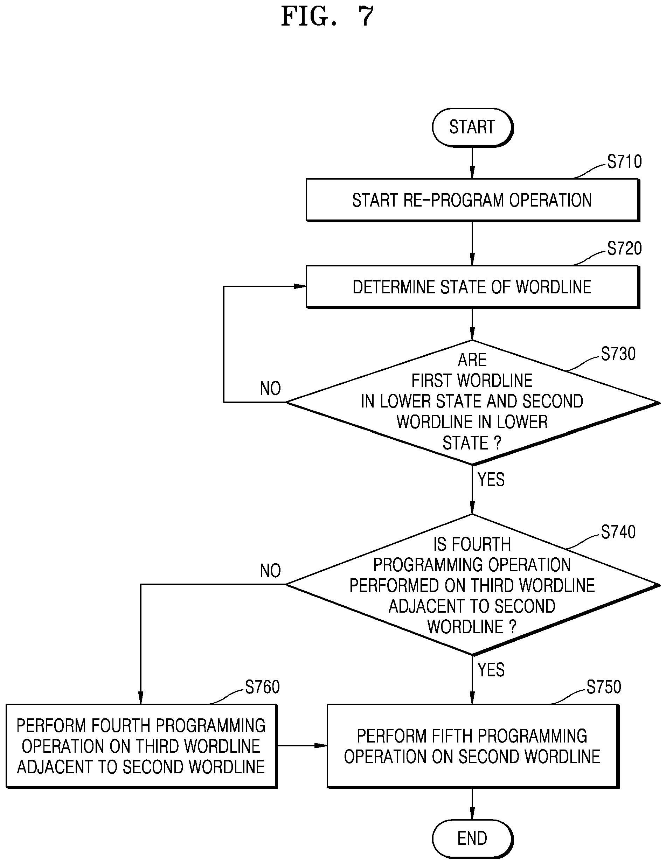

FIG. 7 is a flowchart illustrating a programming process for a memory device when the first wordline is in a lower state and the second wordline is in a lower state, according to an embodiment.

Referring to FIGS. 2 and 7, the memory device 100 according to an embodiment may start a re-program operation (S710).

The re-program operation according to an embodiment may be an operation of performing a programming operation on the first wordline 110 among the wordlines included in the memory device 100, performing a programming operation on the second wordline 120 adjacent to the first wordline 110 after the programming operation on the first wordline 110, and then performing the programming operation again on the first wordline 110 that is not affected by the programming for the second wordline 120. Here, the first wordline 110 may be a victim wordline and the second wordline 120 may be an aggressor wordline. For example, the re-program operation may be an operation to correct a voltage distribution of the victim wordline affected by the programming operation for the aggressor wordline.

When the re-program operation starts, the memory device 100 according to an embodiment may determine the state of the programmed cells connected to the wordlines (S720). The wordlines of the memory device 100 according to an embodiment may include programmed cells in a higher state or a lower state. A higher state according to an embodiment may be a state programmed to have a voltage distribution having a higher level than the threshold voltage, and a lower state may be a state programmed to have a voltage distribution having a lower level than the threshold voltage.

The memory device 100 according to an embodiment may determine whether the first wordline 110 is in a lower state and the second wordline 120 is in a lower state (S730). However, when it is determined that the first wordline 110 is not in a lower state or the second wordline 120 is not in a lower state, the memory device 100 according to an embodiment may determine the state of the wordlines again. The state of the word line can be determined again, and another reprogramming operation can be performed. For example, at least one of steps S710, S810, or S910 can be performed depending on the state of the word line.

If it is determined that the first wordline 110 is in a lower state and the second wordline 120 is in a lower state, the memory device 100 according to an embodiment may determine whether the fourth programming operation is performed on the third wordline 130 adjacent to the second wordline 120 (S740).

For example, the memory device 100 according to an embodiment may perform the second programming operation on the second wordline 120 after performing the first programming operation on the first wordline 110. When the second programming operation is performed, the memory device 100 according to an embodiment may perform the third programming operation on the first wordline 110. The third programming operation may be a re-program operation for the first wordline 110. When the third programming operation is completed, the memory device 100 according to an embodiment may perform the fourth programming operation on the third wordline 130.

If it is determined that the fourth programming operation has been performed on the third wordline 130, the memory device 100 according to an embodiment may perform the fifth programming operation on the second wordline 120 (S750). The fifth programming operation according to an embodiment may be a re-program operation for the second wordline 120.

However, if it is determined that the fourth programming operation has not been performed on the third wordline 130, the memory device 100 according to an embodiment may perform a fourth programming operation on the third wordline 130 adjacent to the second wordline 120 (S760). The memory device 100 according to an embodiment may perform the fifth programming operation on the second wordline 120 after performing the fourth programming operation on the third wordline 130.

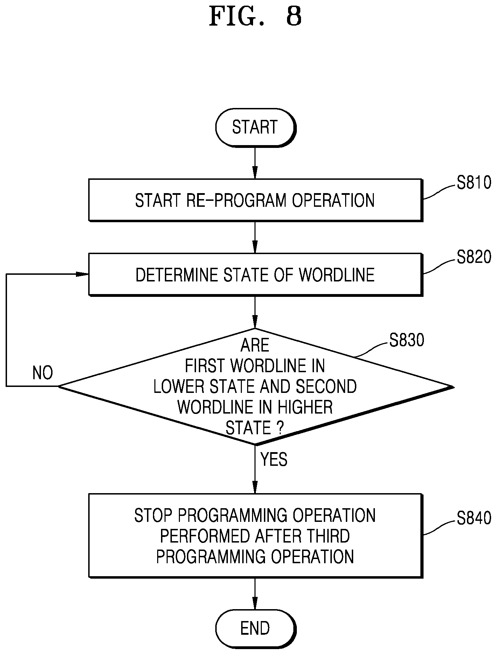

FIG. 8 is a flowchart illustrating a programming process for a memory device when the programmed cells connected to the first wordline are in a lower state and the programmed cells connected to the second wordline are in a higher state, according to an embodiment.

Referring to FIGS. 2 and 8, the memory device 100 according to an embodiment may start a re-program operation (S810).

The re-program operation according to an embodiment may be an operation of performing a programming operation on the first wordline 110 among the wordlines included in the memory device 100, performing a programming operation on the second wordline 120 adjacent to the first wordline 110 after the programming operation on the first wordline 110, and then, performing the programming operation again on the first wordline 110 that is affected by the programming for the second wordline 120. Here, the first wordline 110 may be a victim wordline and the second wordline 120 may be an aggressor wordline. The re-program operation may be an operation to correct a voltage distribution of the victim wordline affected by the programming operation for the aggressor wordline.

When the re-program operation starts, the memory device 100 according to an embodiment may determine the state of the wordlines (S820).

The wordlines of the memory device 100 according to an embodiment may be in a higher state or a lower state. A higher state according to an embodiment may be a state programmed to have a voltage distribution having a higher level than the threshold voltage, and a lower state may be a state programmed to have a voltage distribution having a lower level than the threshold voltage.

The memory device 100 according to an embodiment may determine whether the first wordline 110 is in a lower state and the second wordline 110 is in a higher state (S830).

If it is determined that the first wordline 110 is in a lower state and the second wordline 110 is in a higher state, the memory device 100 according to an embodiment may stop the programming operation performed after the third programming operation. (S840).

According to an embodiment, when the first wordline 110 is in a lower state and the second wordline 120 is in a higher state (e.g. after performance of the second programming operation), the first wordline 110 may be configured to stop the programming operation performed after the third programming operation. For example, the first wordline 110 having a voltage distribution affected by the second programming operation may perform the third programming operation to correct the voltage distribution and may not perform any additional re-program operation.

However, when it is determined that the first wordline 110 is not in a lower state or the second wordline 110 is not in a higher state, the memory device 100 according to an embodiment may determine the states of the wordlines again. The state of the word line can be determined again, and another re-programming operation can be performed. For example, at least one of steps S710, S810, or S910 can be performed depending on the state of the word line.

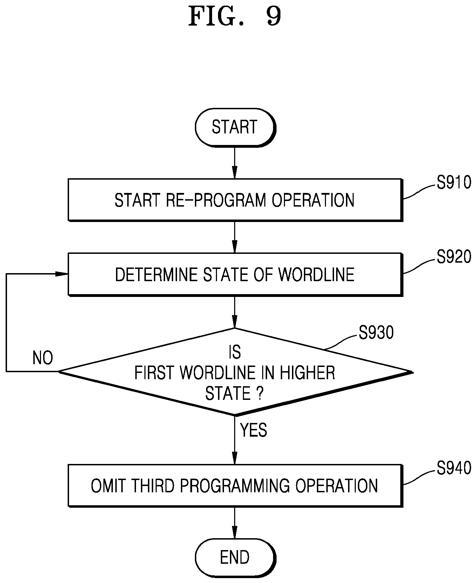

FIG. 9 is a conceptual diagram illustrating a programming process for the memory device 100 when the first wordline is in a higher state, according to an embodiment.

Referring to FIGS. 2 and 9, the memory device 100 according to an embodiment may start a re-program operation (S910).

The re-program operation according to an embodiment may be an operation of performing a programming operation on the first wordline 110 among the wordlines included in the memory device 100, performing a programming operation on the second wordline 120 adjacent to the first wordline 110 after the programming operation on the first wordline 110, and then, performing the programming operation again on the first wordline 110 that is affected by the programming for the second wordline 120. Here, the first wordline 110 may be a victim wordline and the second wordline 120 may be an aggressor wordline. That is, the re-program operation may be an operation to correct a voltage distribution of the victim wordline affected by the programming operation for the aggressor wordline.

When the re-program operation starts, the memory device 100 according to an embodiment may determine the states of the wordlines (S920).

The wordlines of the memory device 100 according to an embodiment may be in a higher state or a lower state (e.g., programmed cells of each wordline may be in a higher state, or may be in a lower state). A higher state according to an embodiment may be a state in which cells are programmed to have a voltage distribution having a higher level than the threshold voltage, and a lower state may be a state in which cells are programmed to have a voltage distribution having a lower level than the threshold voltage.

The memory device 100 according to an embodiment may determine whether the first wordline 110 is in a higher state (S930).

If it is determined that the first wordline 110 is in a higher state, the memory device 100 according to an embodiment may omit the third programming operation (S940).

According to an embodiment, when the first wordline 110 is in a higher state, the first wordline 110 may be configured to omit the third programming operation regardless of the state of the second wordline 120. That is, the third programing operation may only be performed if the first wordline 110 is in a lower state.

For example, when the first programming operation for the first wordline 110 is performed with a distribution having a high voltage exceeding the threshold voltage, the first wordline 110 may omit the third programming operation. When the first wordline 110 according to an embodiment is in a higher state and the second wordline 120 is in a lower state or when the first wordline 110 according to an embodiment is in a higher state and the second wordline 120 is in a higher state, the first wordline 110 may omit the third programming operation. When the first programming operation for the first wordline 110 is performed to exceed the threshold voltage, the first wordline 110 may not be affected by the second programming operation, and the memory device 100 may omit the re-program operation. By omitting the re-program operation, the memory device 100 may have reduced power consumption.

However, if it is determined that the first wordline 110 is not in a higher state, the memory device 100 according to an embodiment may determine the states of the wordlines again. The state of the word line can be determined again, and another re-programming operation can be performed. For example, at least one of steps S710, S810, or S910 can be performed depending on the state of the word line.

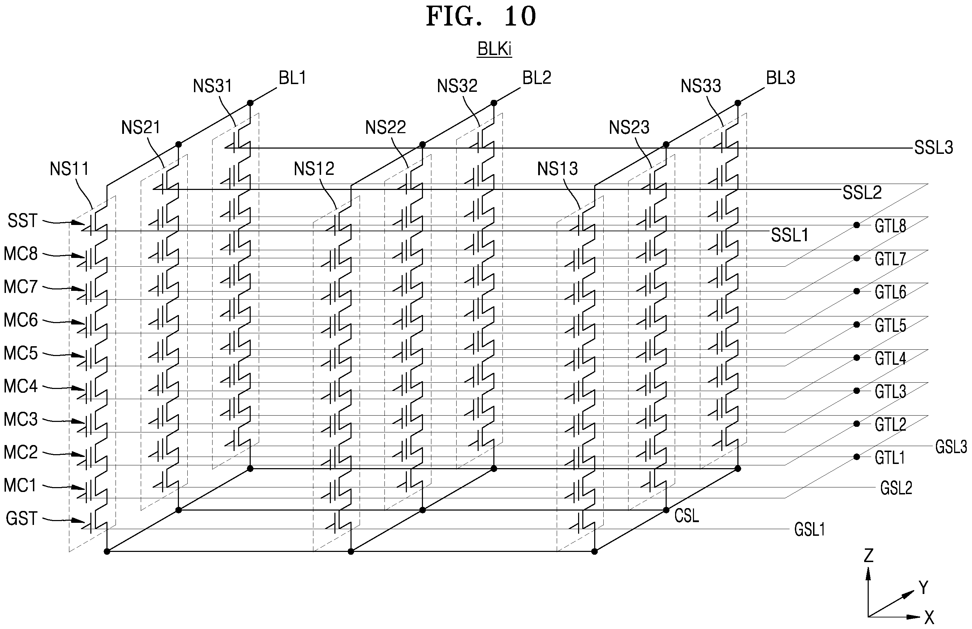

FIGS. 10 to 12 are diagrams illustrating a three-dimensional V-NAND structure that may be applied to the memory device 100 according to an embodiment.

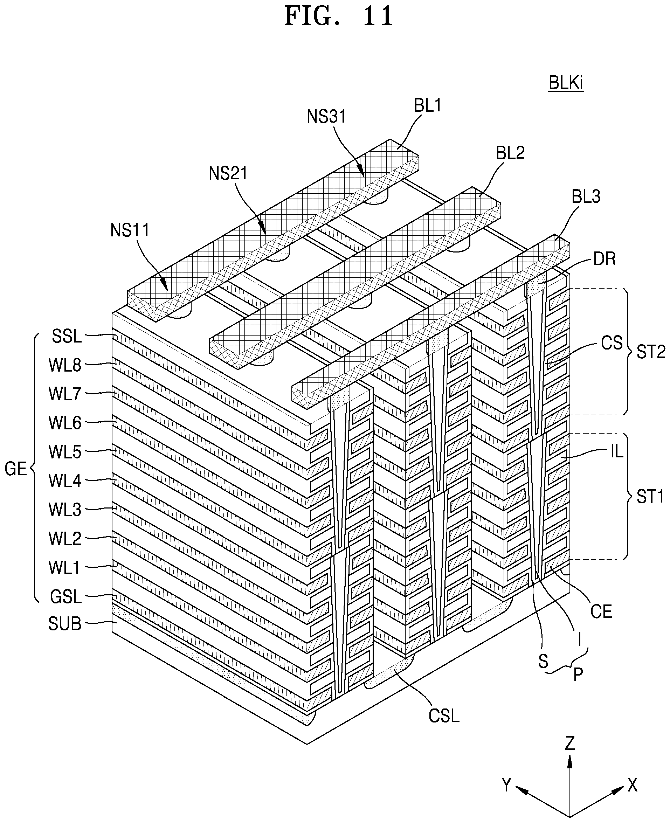

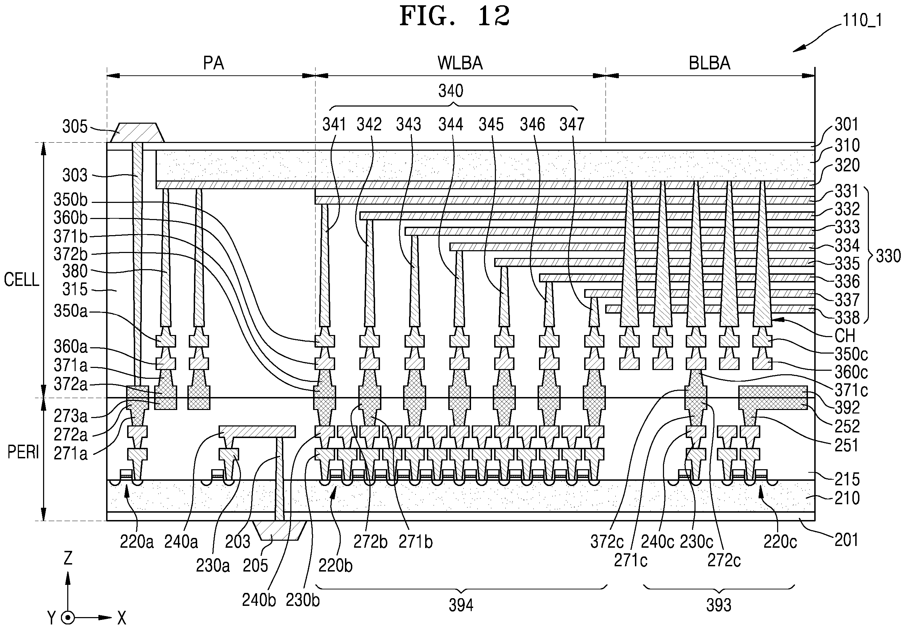

A first non-volatile memory 1000 applicable to the memory device 100 (FIG. 1) may include a plurality of memory blocks. FIGS. 10 and 11 illustrate a structure of one memory block BLKi among a plurality of memory blocks, and FIG. 12 illustrates an implementation example of the non-volatile memory 130 (FIG. 1).

Referring to FIG. 10, the memory block BLKi may include a plurality of memory NAND strings NS11 to NS33 connected between bit lines BL1, BL2, and BL3 and a common source line CSL. Each of the memory NAND strings NS 11 to NS33 may include a string select transistor SST, a plurality of memory cells MC1 to MC8, and a ground select transistor GST. For the sake of brevity of the drawing, FIG. 10 shows that each of the memory NAND strings NS 11 to NS33 includes eight memory cells MC1 to MC8, but is not limited thereto.

The string select transistor SST may be connected to the corresponding string select line of the string select lines SSL1, SSL2, and SSL3. The memory cells MC1 to MC8 may be respectively connected to the corresponding gate lines GTL1 to GTL8. The gate lines GTL1 to GTL8 may correspond to wordlines, and some of the gate lines GTL1 to GTL8 may correspond to dummy wordlines. The ground select transistor GST may be connected to the corresponding ground select line of the ground select lines GSL1, GSL2, and GSL3. The string select transistor SST may be connected to the corresponding bit lines BL1, BL2, and BL3, and the ground select transistor GST may be connected to the common source line CSL.

The gate lines (e.g., GTL1) of the same height may be connected in common, and ground select lines GSL1, GSL2, and GSL3 and string select lines SSL1, SSL2, and SSL3 may be separated from each other. In FIG. 10, the memory block BLK is shown as being connected to eight gate lines GTL1 to GTL8 and three bit lines BL1, BL2, and BL3 but is not limited thereto.

Referring further to FIG. 11, the memory block BLKi is formed in a vertical direction with respect to a substrate SUB. Memory cells constituting the memory NAND strings NS11 to NS33 are formed to be stacked on a plurality of semiconductor layers.

On the substrate SUB, the common source line CSL extending in a first direction (a Y direction) is provided. In a region of the substrate SUB between two adjacent common source lines CSL, a plurality of insulating films IL extending in the first direction (the Y direction) are sequentially provided in a third direction (a Z direction), and the plurality of insulating films IL may be apart from each other by a certain distance in the third direction (the Z direction). A plurality of pillars P are provided to pass through, in the third direction (the Z direction), the insulating films IL which are sequentially arranged in the first direction (the Y direction) in the region of the substrate SUB between two adjacent common source lines CSL. The pillars P may pass through the insulating films IL to contact the substrate SUB. A surface layer S of each pillar P may include a silicon material doped with a first conductivity type and may function as a channel region.

An internal layer I of each pillar P may include an insulating material, such as silicon oxide, or an air gap. In the region between two adjacent common source lines CSL, a charge storage layer CS is provided along exposed surfaces of the insulating films IL, pillars P, and substrate SUB. The charge storage layer CS may include a gate insulating layer (also referred to as a 'tunneling insulating layer'), a charge trap layer, and a blocking insulating layer. In addition, in the region between two adjacent common source lines CSL, the gate electrodes GE, such as select lines GSL and SSL and wordlines WL1 to WL8, are provided on the exposed surface of the charge storage layer CS. GE. Drains or drain contacts DR may be provided on the pillars P, respectively. Bit lines BL1 to BL3 may be provided on the drain contacts DR, extend in the second direction (the X direction), and apart from each other by a certain distance in the first direction (the Y direction).

As shown in FIG. 11, each of the memory NAND strings NS11 to NS33 may be implemented in a structure in which a first memory stack ST1 and a second memory stack ST2 are stacked. The first memory stack ST1 is connected to the common source line CSL, the second memory stack ST2 is connected to the bit lines BL1 to BL3, and the first memory stack ST1 and the second memory stack ST2 are stacked to share channel holes with each other.

FIG. 12 is a diagram illustrating a memory device 400 according to another example embodiment.

Referring to FIG. 12, the memory device 400 may have a chip-to-chip (C2C) structure. The C2C structure may refer to a structure formed by manufacturing an upper chip including a cell region CELL on a first wafer, manufacturing a lower chip including a peripheral circuit region PERI on a second wafer, separate from the first wafer, and then bonding the upper chip and the lower chip to each other. Here, the bonding process may include a method of electrically connecting a bonding metal formed on an uppermost metal layer of the upper chip and a bonding metal formed on an uppermost metal layer of the lower chip. For example, when the bonding metals may include copper (Cu) using Cu-to-Cu bonding. The example embodiment, however, may not be limited thereto. For example, the bonding metals may also be aluminum (Al) or tungsten (W).

Each of the peripheral circuit region PERI and the cell region CELL of the memory device 400 may include an external pad bonding area PA, a wordline bonding area WLBA, and a bit line bonding area BLBA.

The peripheral circuit region PERI may include a first substrate 210, an interlayer insulating layer 215, a plurality of circuit elements 220a, 220b, and 220c formed on the first substrate 210, first metal layers 230a, 230b, and 230c respectively connected to the plurality of circuit elements 220a, 220b, and 220c, and second metal layers 240a, 240b, and 240c respectively formed on the first metal layers 230a, 230b, and 230c. In an example embodiment, the first metal layers 230a, 230b, and 230c may be formed of tungsten having relatively high electrical resistivity, and the second metal layers 240a, 240b, and 240c may be formed of copper having relatively low electrical resistivity.

In an example embodiment illustrated in FIG. 12, although only the first metal layers 230a, 230b, and 230c and the second metal layers 240a, 240b, and 240c are shown and described, the example embodiment is not limited thereto, and one or more additional metal layers may be further formed on the second metal layers 240a, 240b, and 240c. At least a portion of the one or more additional metal layers formed on the second metal layers 240a, 240b, and 240c may be formed of aluminum or the like having lower electrical resistivity than those of copper forming the second metal layers 240a, 240b, and 240c.

The interlayer insulating layer 215 may be disposed on the first substrate 210 and cover the plurality of circuit elements 220a, 220b, and 220c, the first metal layers 230a, 230b, and 230c, and the second metal layers 240a, 240b, and 240c. The interlayer insulating layer 215 may include an insulating material, such as silicon oxide, silicon nitride, or the like.

Lower bonding metals 271b and 272b may be formed on the second metal layer 240b in the wordline bonding area WLBA. In the wordline bonding area WLBA, the lower bonding metals 271b and 272b in the peripheral circuit region PERI may be electrically bonded to upper bonding metals 371b and 372b of the cell region CELL. The lower bonding metals 271b and 272b and the upper bonding metals 371b and 372b may be formed of aluminum, copper, tungsten, or the like. Furthermore, the upper bonding metals 371b and 372b in the cell region CELL may be referred as first metal pads and the lower bonding metals 5271b and 5272b in the peripheral circuit region PERI may be referred as second metal pads.

The cell region CELL may include at least one memory block. The cell region CELL may include a second substrate 310 and a common source line 320. On the second substrate 310, a plurality of wordlines 331 to 338 (i.e., 330) may be stacked in a direction (a Z-axis direction), perpendicular to an upper surface of the second substrate 310. At least one string select line and at least one ground select line may be arranged on and below the plurality of wordlines 330, respectively, and the plurality of wordlines 330 may be disposed between the at least one string select line and the at least one ground select line.

In the bit line bonding area BLBA, a channel structure CH may extend in a direction (a Z-axis direction), perpendicular to the upper surface of the second substrate 310 and pass through the plurality of wordlines 330, the at least one string select line, and the at least one ground select line. The channel structure CH may include a data storage layer, a channel layer, a buried insulating layer, and the like, and the channel layer may be electrically connected to a first metal layer 350c and a second metal layer 360c. For example, the first metal layer 350c may be a bit line contact, and the second metal layer 360c may be a bit line. In an example embodiment, the bit line 360c may extend in a first direction (a Y-axis direction), parallel to the upper surface of the second substrate 310.

In an example embodiment illustrated in FIG. 12, an area in which the channel structure CH, the bit line 360c, and the like are disposed may be defined as the bit line bonding area BLBA. In the bit line bonding area BLBA, the bit line 360c may be electrically connected to the circuit elements 220c providing a page buffer 393 in the peripheral circuit region PERI. The bit line 360c may be connected to upper bonding metals 371c and 372c in the cell region CELL, and the upper bonding metals 371c and 372c may be connected to lower bonding metals 271c and 272c connected to the circuit elements 220c of the page buffer 393.

In the wordline bonding area WLBA, the plurality of wordlines 330 may extend in a second direction (an X-axis direction), parallel to the upper surface of the second substrate 310 and perpendicular to the first direction, and may be connected to a plurality of cell contact plugs 341 to 347 (i.e., 340). The plurality of wordlines 330 and the plurality of cell contact plugs 340 may be connected to each other in pads provided by at least a portion of the plurality of wordlines 330 extending in different lengths in the second direction. A first metal layer 350b and a second metal layer 360b may be connected to an upper portion of the plurality of cell contact plugs 340 connected to the plurality of wordlines 330, sequentially. The plurality of cell contact plugs 340 may be connected to the peripheral circuit region PERI by the upper bonding metals 371b and 372b of the cell region CELL and the lower bonding metals 271b and 272b of the peripheral circuit region PERI in the wordline bonding area WLBA.

The plurality of cell contact plugs 340 may be electrically connected to the circuit elements 220b forming a row decoder 394 in the peripheral circuit region PERI. In an example embodiment, operating voltages of the circuit elements 220b of the row decoder 394 may be different than operating voltages of the circuit elements 220c forming the page buffer 393. For example, operating voltages of the circuit elements 220c forming the page buffer 393 may be greater than operating voltages of the circuit elements 220b forming the row decoder 394.

A common source line contact plug 380 may be disposed in the external pad bonding area PA. The common source line contact plug 380 may be formed of a conductive material, such as a metal, a metal compound, polysilicon, or the like, and may be electrically connected to the common source line 320. A first metal layer 350a and a second metal layer 360a may be stacked on an upper portion of the common source line contact plug 380, sequentially. For example, an area in which the common source line contact plug 380, the first metal layer 350a, and the second metal layer 360a are disposed may be defined as the external pad bonding area PA.

Input-output pads 205 and 305 may be disposed in the external pad bonding area PA. Referring to FIG. 12, a lower insulating film 201 covering a lower surface of the first substrate 210 may be formed below the first substrate 210, and a first input-output pad 205 may be formed on the lower insulating film 201. The first input-output pad 205 may be connected to at least one of the plurality of circuit elements 220a, 220b, and 220c disposed in the peripheral circuit region PERI through a first input-output contact plug 203, and may be separated from the first substrate 210 by the lower insulating film 201. In addition, a side insulating film may be disposed between the first input-output contact plug 203 and the first substrate 210 to electrically separate the first input-output contact plug 203 and the first substrate 210.

Referring to FIG. 12, an upper insulating film 301 the upper surface of the second substrate 310 may be formed covering on the second substrate 310, and a second input-output pad 305 may be disposed on the upper insulating layer 301. The second input-output pad 305 may be connected to at least one of the plurality of circuit elements 220a, 220b, and 220c disposed in the peripheral circuit region PERI through a second input-output contact plug 303. In the example embodiment, the second input-output pad 305 is electrically connected to a circuit element 220a.

According to embodiments, the second substrate 310 and the common source line 320 may not be disposed in an area in which the second input-output contact plug 303 is disposed. Also, the second input-output pad 305 may not overlap the wordlines 330 in the third direction (the Z-axis direction). Referring to FIG. 12, the second input-output contact plug 303 may be separated from the second substrate 310 in a direction, parallel to the upper surface of the second substrate 310, and may pass through the interlayer insulating layer 315 of the cell region CELL to be connected to the second input-output pad 305.

According to embodiments, the first input-output pad 205 and the second input-output pad 305 may be selectively formed. For example, the memory device 400 may include only the first input-output pad 205 disposed on the first substrate 210 or the second input-output pad 305 disposed on the second substrate 310. Alternatively, the memory device 400 may include both the first input-output pad 205 and the second input-output pad 305.

A metal pattern provided on an uppermost metal layer may be provided as a dummy pattern or the uppermost metal layer may be absent, in each of the external pad bonding area PA and the bit line bonding area BLBA, respectively included in the cell region CELL and the peripheral circuit region PERI.

In the external pad bonding area PA, the memory device 400 may include a lower metal pattern 273a, corresponding to an upper metal pattern 372a formed in an uppermost metal layer of the cell region CELL, and having the same cross-sectional shape as the upper metal pattern 372a of the cell region CELL so as to be connected to each other, in an uppermost metal layer of the peripheral circuit region PERI. In the peripheral circuit region PERI, the lower metal pattern 273a formed in the uppermost metal layer of the peripheral circuit region PERI may not be connected to a contact. Similarly, in the external pad bonding area PA, an upper metal pattern 372a, corresponding to the lower metal pattern 273a formed in an uppermost metal layer of the peripheral circuit region PERI, and having the same shape as a lower metal pattern 273a of the peripheral circuit region PERI, may be formed in an uppermost metal layer of the cell region CELL.

The lower bonding metals 271b and 272b may be formed on the second metal layer 240b in the wordline bonding area WLBA. In the wordline bonding area WLBA, the lower bonding metals 271b and 272b of the peripheral circuit region PERI may be electrically connected to the upper bonding metals 371b and 372b of the cell region CELL by a Cu-to-Cu bonding.

Furthermore, in the bit line bonding area BLBA, an upper metal pattern 392, corresponding to a lower metal pattern 252 formed in the uppermost metal layer of the peripheral circuit region PERI, and having the same cross-sectional shape as the lower metal pattern 252 of the peripheral circuit region PERI, may be formed in an uppermost metal layer of the cell region CELL. A contact may not be formed on the upper metal pattern 392 formed in the uppermost metal layer of the cell region CELL.

In an example embodiment, corresponding to a metal pattern formed in an uppermost metal layer in one of the cell region CELL and the peripheral circuit region PERI, a reinforcement metal pattern having the same cross-sectional shape as the metal pattern may be formed in an uppermost metal layer in the other one of the cell region CELL and the peripheral circuit region PERI. A contact may not be formed on the reinforcement metal pattern.

While the inventive concept has been particularly shown and described with reference to embodiments thereof, it will be understood that various changes in form and details may be made therein without departing from the scope of the following claims.

## Claims

1. A memory device including a plurality of memory cells configured to store at least one bit, the memory device comprising a first wordline and a second wordline, and configured to:
perform a first programming operation on the first wordline;
perform a second programming operation on the second wordline; and
perform a third programming operation with a voltage lower than a voltage of the first programming operation when the second programming operation is performed after the first programming operation is performed.

2. The memory device of claim 1, wherein the first wordline is a victim wordline, and the second wordline is an aggressor wordline.

3. The memory device of claim 1 or claim 2, wherein the memory device is configured to, when the plurality of memory cells of the first wordline are in a lower state and a plurality of memory cells of the second wordline are in a lower state, the lower state referring to a state in which the plurality of memory cells have threshold voltages below a particular voltage, perform a fifth programming operation on the second wordline when a fourth programming operation is performed on a third wordline adjacent to the second wordline.

4. The memory device of any preceding claim, wherein the memory device is configured to stop an additional programming operation from being performed on the first wordline after the third programming operation when the plurality of memory cells of the first wordline are in a lower state and the plurality of memory cells of the second wordline are in a higher state, the lower state referring to a state in which the plurality of memory cells have threshold voltages below a particular voltage, and the higher state referring to a state in which the plurality of memory cells have threshold voltages above the particular voltage.

5. The memory device of any preceding claim, wherein the memory device is configured to omit the third programming operation on the first wordline when the plurality of memory cells of the first wordline are in a higher state, the higher state referring to a state in which the plurality of memory cells have threshold voltages above the particular voltage.

6. The memory device of any preceding claim, wherein the first wordline and the second wordline are configured to include a quad level cell or triple level cell.

7. The memory device of any preceding claim, wherein the first wordline is configured to perform the first programming operation using a voltage higher than a threshold voltage of a memory cell.

8. An operating method of a memory device including a plurality of memory cells each storing at least one bit, the operating method comprising:
performing a first programming operation on memory cells connected to a first wordline, including applying a first voltage to the first wordline; and
performing a second programming operation on memory cells connected to a second wordline adjacent to the first wordline, including applying a second voltage to the second wordline,
wherein, in the performing of the first programming operation, the first programming operation is performed on memory cells, and
wherein, when the second programming operation is performed after the first programming operation is performed, a third programming operation is performed on the memory cells connected to the first wordline, including applying a third voltage lower than the first voltage to the first wordline.

9. The operating method of claim 8, further comprising:
when the memory cells connected to the first wordline are in a lower state and the memory cells connected to the second wordline are in a lower state,
performing a fifth programming operation on the second wordline after a fourth programming operation is performed on a third wordline adjacent to the second wordline, the lower state referring to a state in which the memory cells have a threshold voltage below a particular voltage.

10. The operating method of claim 8 or claim 9, further comprising:
when the memory cells connected to the first wordline are in a lower state, the lower state referring to a state in which the memory cells have a threshold voltage below a particular voltage, and the memory cells connected to the second wordline are in the higher state,
stopping a programming operation performed after the third programming operation.

11. The operating method of any of claims 8-10, further comprising,
when the first wordline is in a higher state, omitting the third programming operation.

12. The operating method of any of claims 8-11, wherein the performing of the first programming operation and the performing of the second programming operation include performing a predefined programming operation on a quad level cell or a triple level cell.

13. The operating method of any of claims 8-12, wherein, in the performing of the first programming operation, the first programming operation is performed using a voltage higher than a threshold voltage of a memory cell.

14. A memory system including:
a host configured to generate a re-program command for a wordline; and
a memory device configured to receive the re-program command, the memory device including a plurality of memory cells each storing at least one bit, and configured to performing a re-program operation,
wherein the memory device includes:
a first wordline on which a first programming operation is configured to be performed; and
a second wordline on which a second programming operation is configured to be performed,
wherein the memory device is configured to:
perform the first programming operation on a memory cell; and
perform a third programming operation with a voltage lower than a voltage for the first programming operation when the second programming operation is performed after the first programming operation is performed.

15. The memory system of claim 14, wherein the first wordline is a victim wordline, and the second wordline is an aggressor wordline.
